# EUROPÄISCHE PATENTANMELDUNG

(11) **EP 4 068 343 A1**
(43) Veröffentlichungstag der Anmeldung: **05.10.2022**
(21) Anmeldenummer: 21166539.3
(22) Anmeldetag: 01.04.2021
(51) Int. Cl.: H01L 21/673

(54) **VORRICHTUNG ZUM TRANSPORT VON HALBLEITERSCHEIBEN**

(71) Anmelder: Siltronic AG, 81677 München (DE)
(72) Erfinder: Lamprecht, Ludwig, 83376 Truchtlaching (DE); Vogel, Thoralf, 09514 Lengefeld (DE)

(57) **Zusammenfassung**

Transportbehälter zum Transport von Halbleiterscheiben, der aus einem Grundmaterial mittels eines 3D Drucks mit einer vorgegebenen Form erzeugt wurde, wobei zumindest ein Bereich einer Oberfläche des Transportbehälters ein Beschichtungsmaterial zum Schutz gegen Chemikalien aufweist, die geeignet sind, die Halbleiterscheiben zu ätzen, wobei das Beschichtungsmaterial mittels eines Niedertemperatur-Beschichtungsverfahrens, insbesondere eines Niedertemperatur-Sinterverfahrens, bevorzugt mit einer Temperatur unterhalb von 150°C, aufgebracht wurde, und das Beschichtungsmaterial aus Polytetrafluorethylen, Perfluoralkoxy-Polymer oder Polyvinylidenfluorid besteht, wobei die vorgegebene Form des Transportbehälters im Boden eine Vorrichtung enthält, die geeignet ist, flüssige Medien abzuführen, und die vorgegebene Form des Transportbehälters eine oder mehrere integrierte Werkstückaufnahmen für Halbleiterscheiben und/oder Träger für Halbleiterscheiben aufweist, so dass die zu transportierenden Halbleiterscheiben stehend beladen werden können und die bestimmungsgemäße Transportrichtung des Transportbehälters in einem automatischen Transportsystem parallel zu deren Vorder- oder Rückseite der Halbleiterscheiben verläuft.

## Beschreibung

Die vorliegende Erfindung betrifft eine Vorrichtung in Form eines Transportbehälters für Halbleiterscheiben, der für die Verwendung in einem oberen Hebezeug Transport geeignet ist.

### Stand der Technik

Bei der Herstellung und Bearbeitung von Halbleiterscheiben (Wafer) aus Silizium oder anderen Halbleitermaterialien werden zwischen den einzelnen Prozessschritten Transportbehälter verwendet, um diese Halbleiterscheiben zu transportieren und/oder in bestimmter Ausrichtung halten zu können.

Die Transportbehälter sind in der Regel dabei so ausgestaltet, dass Wafer-Horden zusammen mit den Wafern in die Behälter gestellt und manuell oder mit einem automatisch agierenden Fahrzeug (AGV, automated guided vehicle) transportiert werden können.

Das Be- und Entladen der Wafer-Horden aus den Transportbehältern nimmt je nach Automatisierungsgrad viel Zeit in Anspruch.

Durch die vielen Bewegungen beim Transport erhöht sich zudem das Risiko der Beschädigung der transportierten Wafer.

Zum einen gibt es bodengebundene Transportsysteme, die zum Beispiel mit automatisch agierenden Fahrzeugen (AGV) oder mit manuell geschobenen Wagen auf dem Boden des Reinraums betrieben werden.

Zum anderen gibt es deckengebundene Transportsysteme, die an einem Schienensystem, das an der Decke des Reinraums befestigt ist, betrieben werden. Besonders vorteilhaft ist hierbei die Verwendung eines oberen Hebezeug Transports.

Bodengebundene Transportsysteme mit manuell geschobenen Wagen oder AGV benötigen zwischen den Prozessanlagen dafür vorgesehene Transportwege. Innerhalb von Reinräumen führt dies zu kostspieligen zusätzlichen Reinraumflächen und teilweise langen Transportwegen, da die direkten Strecken durch das Prozessequipment belegt sind.

Die Verwendung eines oberen Hebezeug Transports ("Overhead Hoist Transport", OHT) überwindet dabei die genannten Nachteile, da die Wafer zum Beispiel unter der Decke transportiert werden können und so nicht zusätzliche Reinraumflächen beanspruchen. Ein Beispiel hierfür ist in der Anmeldung US 2015 104 276 AA aufgezeigt.

Transportbehälter für Halbleiterscheiben können als tiefgezogene, gespritzte, gegossene oder geschweißte Behälter angefertigt werden. Durch diese Fertigungsverfahren sind, wie sich gezeigt hat, Formgebung und Funktionsmerkmale der Behälter allerdings nur eingeschränkt realisierbar.

Die Schrift US 2004/206663 A1 beschreibt einen Behälter mit ultraphoben Oberflächen zur Förderung einer effektiveren Reinigung und Trocknung des Behälters.

Die Schrift WO 2004/005163 A1 bezieht sich auf einen Transportbehälter für Wafer, wobei Teile davon aus feuerhemmenden Materialien hergestellt wurden.

Die Schrift US 2005/236110A1 bezieht sich allgemein auf ein System und ein Verfahren zum Einbringen einer dünnen Thermopolymer-Schutzfolie, wie z. B. PEEK, in den Formgebungsprozess für Handgeräte, Transporter, Träger, Schalen und ähnliche Geräte, die in der Halbleiterverarbeitungsindustrie verwendet werden.

Die Schrift DE 42 23 326 A1 bezieht sich auf einen Träger für Halbleiterscheiben mit einem Trägerunterbau, wobei zumindest auf einem Abschnitt des Unterbaus ein Diamantüberzug vorgesehen ist.

Ein Trägersystem, in der Halbleiterfertigung auch "Loadport" genannt, stellen sowohl die mechanische als auch die elektrische Schnittstelle zwischen einem Transportbehälter und einer Prozessanlage dar. Auf ihm werden die Transportbehälter durch das Transportsystem abgestellt, um die Prozessanlage zu be- und entladen. Verbreitet sind hier SEMI-Norm-konforme Loadports im Einsatz, die eine Bestückung von gängigen Halbleitertransportboxen wie FOUP (Acronym für "Front Opening Unified Pod"), FOSB (Acronym für "Front Opening Shipping Boxes"), OC (Acronym für "Open Cassette"), SMIF-Pods (Acronym für "Standard Mechanical Interface") zulassen.

Es besteht daher Bedarf an verbesserten Transportbehältern für Halbleiterscheiben, die den Einsatz in Verbindung mit Systemen eines oberen Hebezeug Transport (Overhead Hoist Transport, OHT), speziell auch für den Nasstransport von Halbleiterscheiben und deren Herstellung ermöglichen.

### Offenbarung der Erfindung

Erfindungsgemäß wird ein Transportbehälter für Halbleiterscheiben mit den Merkmalen der unabhängigen Patentansprüche vorgeschlagen. Vorteilhafte Ausgestaltungen sind Gegenstand der Unteransprüche sowie der nachfolgenden Beschreibung.

Die Erfindung beschäftigt sich mit einem Transportbehälter für Halbleiterscheiben wie z.B. Siliziumwafer. Dabei wird aus einem Grundmaterial mittels eines additiven Aufbau- bzw. Herstellungsverfahrens - hierbei kann es sich insbesondere um einen sog. 3-D-Druck handeln - ein Behälter mit einer vorgegebenen Form erzeugt. Es wird also z.B. das Grundmaterial Schicht für Schicht aufeinander gefügt, bis letztlich die gewünschte, vorgegebene Form entstanden ist. Anschließend wird zumindest in vorbestimmten Bereichen einer Oberfläche des (auf diese Weise aufgebauten) Behälters ein Beschichtungsmaterial zum Schutz gegen Chemikalien aufgebracht, d.h. der Behälter wird mittels einer Beschichtung (die als Schutzschicht dient) chemikalienbeständig gemacht.

Bei dem beschichteten Behälter kann dann von dem Transportbehälter gesprochen werden. Die hierbei relevanten Bereiche der Oberfläche, auf die das Beschichtungsmaterial aufgebracht wird, sind insbesondere solche Bereiche, die später bei der Verwendung mit entsprechenden Medien oder Chemikalien in Berührung kommen und daher geschützt werden sollten. Dies betrifft insbesondere die Innenseite des - typischerweise oben offenen - Behälters. Besonders vorteilhaft ist es jedoch, wenn ein Transportbehälter einen Deckel aufweist, der insbesondere dicht gegenüber Flüssigkeiten ist, die die innere Oberfläche des Deckels benetzen.

Mittels eines additiven Aufbauverfahrens bzw. mittels 3-D-Druck lassen sich gegenüber konventionellen Herstellungsverfahren in vielerlei Hinsicht optimierte Transportbehälter, z.B. für Trocken- oder Nasstransporte mit AGV- und Overhead Hoist-Transportsystemen anfertigen. Dies ist insbesondere aufgrund frei gestaltbarer Formgebung inkl. integrierter mechanischer Konstruktionselemente als Teil des auf diese Weise hergestellten Behälters möglich, und zwar ohne Zusatzkomponenten, die nachträglich mit den herkömmlich hergestellten Behältern verbunden werden müssen.

Zusätzlich sind chemische Beständigkeit, Oberflächenbeschaffenheit, integrierte und aufladbare Spannungsversorgungen, mechanische Kopplungselemente, Sensoren, Kupplungen für externe Energie- und Medienversorgungen, integrierte Aufnahmen für Halbleiterscheiben und fluidtechnische Funktionsmerkmale für die jeweiligen Anwendungen gegenüber den herkömmlichen Herstellverfahren variabler und angepasster wählbar, wie nachfolgend noch näher erläutert werden soll.

Eine verbesserte oder gar optimierte Chemikalienbeständigkeit wird durch das Aufbringen des Beschichtungsmaterials, die als Oberflächenversiegelung dient bzw. eine solche bewirkt, erreicht. Bevorzugte Beschichtungsmaterialien sind dabei Polytetrafluorethylen, PTFE, Perfluoralkoxy-Polymer, PFA, sowie Polyvinylidenfluorid, PVDF.

Die Erfinder haben erkannt, dass Behälter, die ausschließlich aus einem Grundmaterial mittels eines additiven Aufbauverfahrens wie 3-D-Druck hergestellt wurden, nicht als Transportbehälter für Halbleiterscheiben verwendet werden können, da die Rauheit der Oberflächen zu stark ausgeprägt ist. Die Oberflächen weisen eine starke Rauheit für die gewünschte Verwendung auf, was zur Folge hat, dass sich organische und anorganische Verschmutzungen an den Oberflächen ein- und anlagern, was die Qualität der zu transportierenden Halbleiterscheiben negativ beeinflusst.

Durch die Beschichtung mit z.B. PTFE auf den relevanten Oberflächen eines mittels eines additiven Aufbauverfahrens hergestellten Behälters (3D Druck ist es nunmehr jedoch möglich, die positiven Eigenschaften eines auf herkömmliche Art hergestellten Transportbehälters (also insbesondere die Chemikalienbeständigkeit) mit den positiven Eigenschaften eines mittels eines additiven Aufbauverfahrens hergestellten Behälters für Halbleiterscheiben, typischerweise Silizium-Wafer (also insbesondere die freie Formgebung) zu verbinden.

Da ein mittels eines additiven Aufbauverfahrens hergestellter Behälter bei herkömmlichen Beschichtungsverfahren thermisch stark belastet wird und sich dadurch verformen würde, wurde ein Niedertemperatur-Beschichtungsverfahren in Kombination mit dem additiven Aufbauverfahren entwickelt.

Herkömmlicherweise werden die für die Prozesse bei Halbleiterscheiben erforderlichen hoch reinen Beschichtungen bei hohen Temperaturen auf Oberflächen aufgebracht.

Durch ein gezielt eingesetztes Niedertemperatur-Beschichtungsverfahren, bevorzugt mit einer Temperatur unterhalb von 150°C, lassen sich Beschichtungen hoher Reinheit auch auf die weniger temperaturstabilen Oberflächen von z.B. 3-D-gedruckten Behältern aufbringen und somit die Vorteile wie freie Formgebung, gezielte Zu- bzw. Abführung der Chemikalien in den Transportbehälter und die chemischen und physikalischen Eigenschaften zusammenführen.

Beispielsweise weist das Material PA 3200GF eine Formbeständigkeitstemperatur (bei einem Druck von 0,45 MPa und in X-Richtung) von max. 157°C nach ISO 75-1/-2 auf. Vergleichbares gilt für die bevorzugten Grundmaterialien, die ein Polyamid, insbesondere mit Füllstoffen, aufweisen. Wird diese Temperatur überschritten, fällt die plastische Kontur typischerweise in sich zusammen. PTFE-Beschichtungen z.B. werden in der Regel aufgespritzt und in einem Ofen bei einer Temperatur von etwa 220°C bis 420°C gesintert. Durch ein Nieder-Temperatur-Sinterverfahren, das sich typischerweise über einen längeren Zeitraum bei z.B. 100°C erstreckt, konnte erreicht werden, einen 3-D-gedruckten Behälter für Silizium-Wafer chemie- und schmutzresistent zu machen.

Eine Oberflächenrauigkeit der mittels eines additiven Aufbauverfahrens (3D Druck) hergestellten Behälter lässt sich durch Niedertemperatur-Beschichtungen reduzieren - typischerweise lassen sich die Rz- und Ra-Werte (die die Rauheit spezifizieren) um ca. 70 % gegenüber den entsprechenden Werten des Behälters ohne die Niedertemperatur-Beschichtung reduzieren. Dies trägt damit auch dazu bei, dass Partikel oder andere organische oder anorganische Bestandteile der Flüssigkeiten im Transportbehälter deutlich weniger an den Oberflächen (des Behälters) anhaften und dadurch deutlich leichter und gezielt entfernt werden können, wenn die Flüssigkeit gewechselt werden soll.

Das vorgeschlagene additive Aufbauverfahren (3D Druck) erlaubt optimierte Behälterausführungen, d.h. hinsichtlich der Form und Adaptierbarkeit für den Einsatz in Kombination mit Overhead Hoist Transportsystemen, optimierte Transportbehälter. So ist damit z.B. ein gewichtoptimiertes Flüssigkeitsvolumen des Transportbehälters durch die fertigungstechnisch leicht anpassbare Form des Behälters an die darin transportierten Halbleiterscheiben möglich, sodass bei Verwendung des Transportbehälters keine unnötig hohen Mengen an Medium oder Chemikalien benötigt werden (d.h. das Volumen, in dem Flüssigkeit aufgenommen wird, ist z.B. so gering wie möglich gehalten).

Besonders bevorzugt weist die vorgegebene Form des Behälters eine Abführung für Medien oder Chemikalien auf, besonders bevorzugt sind auch mehrere Zu- und/oder Abführungen.

Besonders bevorzugt sind auch eine oder mehrere integrierte Werkstückaufnahmen für eine oder mehrere Halbleiterscheiben oder Träger hierfür. Eine Werkstückaufnahme kann z.B. derart gestaltet sein, dass darin direkt eine oder mehrere Halbleiterscheiben eingebracht und gehalten werden können.

Ebenso kann eine Werkstückaufnahme bevorzugt auch derart gestaltet sein, dass darin ein Träger, eine Kassette oder eine andere Halterung eingebracht werden kann, in der dann wiederum eine oder bevorzugt mehrere Halbleiterscheiben eingebracht und gehalten werden können. Bevorzugt wird in eine Werkstückaufnahme ein Wafer-Halterung (Kassette) für fünf, zehn, fünfzehn oder fünfundzwanzig Siliziumwafer eingebracht, sodass diese Siliziumwafer zusammen eingebracht bzw. entnommen werden können, ohne dabei die Wafer zusammen mit den Wafer-Horden, einbringen oder entnehmen zu müssen.

In der Halbleiterfertigung ist dabei der Begriff "Batch Handling" üblich. Dabei wird die gesamte Menge an Wafern, in den 3D gedruckten Transportbehälter und in die darin befindliche Wafer-Aufnahmen, gleichzeitig oder einzeln hineingebracht oder entnommen. Die zeitaufwendigen Belade- und Entladevorgänge mit Wafer-Horden entfallen dadurch. Durch das Eliminieren der Horden-Beladung und der Horden-Entladung verringert sich zusätzlich auch das Risiko einer Beschädigung der Wafer an den Grenzflächen zu den Horden durch Erschütterungen.

Bevorzugt sind zudem einer oder mehrere Rahmen und/oder eine oder mehrere Befestigungseinrichtungen zur Anbringung und automatischen Ankopplung an unterschiedliche Prozessanlagen vorgesehen. Insbesondere sind in die Behälterform integrierte Versteifungen bevorzugt.

Die automatische Ankopplung des Transportbehälters an Prozessanlagen erfolgt bevorzugt in Verbindung mit Overhead Hoist Transportsystemen durch das Aufsetzen der Behälter auf dafür an Prozessanlagen integrierte mechanische, elektrische, datentechnische und / oder fluidtechnische Kopplungselemente.

Bevorzugt kommen hierbei drei oder mehr mechanische Kopplungselemente zum Einsatz. Deren Ausführung im Kontaktbereich zum Transportbehälter kann in Form von Pins mit gefastem, gerundetem, kegelförmigem oder kegelstumpfförmigen Kopfstück als auch in Rollenform erfolgen. Die Anordnung auf einem Trägersystem kann rotationssymmetrisch, achsensymmetrisch oder in der Fläche unsymmetrisch verteilt sein. Das Trägersystem kann zusätzliche Formelemente enthalten, welche eine Vorpositionierung des zu platzierenden Transportbehälters in horizontaler X-Y-Richtung erlauben. Weiterhin können auf dem Trägersystem Stabilisierungselemente angeordnet sein, die ein seitliches Kippen des Transportbehälters verhindern.

Das Gewicht von gefüllten Transportbehälter ist dabei bevorzugt mehr als 25kg und kleiner als 120kg.

In den Transportbehältern sind bevorzugt erforderliche Gegenstücke integriert, die durch besonders bevorzugt formschlüssige Verbindungen durch das Aufsetzen der Behälter die mechanischen, elektrischen und / oder fluidtechnischen Verbindungen zwischen Prozessanlagen und Transportbehälter herstellen.

Zu- bzw. Abführungen können bevorzugt in die Form integriert werden und sind dabei beliebig gestaltbar.

Bei herkömmlich angefertigten Transportbehältern werden Zu- bzw. Abführungen, Zuleitungen und Adapter typischerweise mittels zusätzlicher Rohrleitungen, Elektroleitungen und mechanischen Adapter inkl. Befestigungen an dem Behälter realisiert.

Das additive Aufbauverfahren bzw. der 3-D-Druck ermöglicht demgegenüber die Integration solcher Element in die Behälterform, z. B. in seitlichen Wänden oder den Boden und die gezielte Anordnung der Ein- bzw. Austrittsöffnung an solchen Stellen, die für eine schnelle und räumlich nahe Zuführung der Medien, Strom- und Datenverbindungen und zur mechanischen Kopplung der Behälter mit den Prozessanlagen oder Transportsystemen, z.B. Overhead Hoist Transportsystem, ideal sind. Dies kann dabei bevorzugt auch je nach gewünschter Verwendung des Transportbehälters für unterschiedliche Transportsysteme, z.B. AGV oder Overhead Hoist Transportsysteme, wofür er hauptsächlich verwendet werden soll, gezielt gestaltet werden.

Speziell für die Anwendung als Nasstransportbehälter für Overhead Hoist Transport Systeme lässt sich durch ein additives Herstellverfahren, z.B. 3 D -Druckverfahren, der obere Behälterrand für die Aufnahme des Behälters durch das sogenannte Shuttle (Transportfahrzeug des OHT), das bevorzugt mit absenkbaren Aufnahmevorrichtungen für Behälter ausgestattet ist, sehr passgenau und einfach gestalten und herstellen. Durch die passgenaue Herstellung wird sichergestellt, dass die Behälter auch mit handelsüblichen Overhead Hoist Transportsystemen verwenden zu können.

Die Erfinder haben erkannt, dass durch das additive Herstellverfahren für eine Vielzahl von identisch ausgeführten Transportbehältern speziell die integrierten, mechanischen Kopplungselemente sehr positionsgenau integriert werden können. Die absolute Positionsgenauigkeit der mechanischen Kopplungselemente in Verbindung mit den mittel additiven Herstellverfahren integrierten Wafer-Aufnahmen sind Voraussetzung für identische durchgeführte Be-/Entladevorgänge an unterschiedlichen Prozess-Equipment, ohne die Be-/Entladevorrichtungen, z.B. Wafer-Be/Entladeroboter, für jeden Transportbehälter separat einrichten zu müssen. Eine hohe Reproduzierbarkeit des Prozessablaufes kann somit gewährleistet werden.

Die Erfinder haben ferner erkannt, dass speziell die Anwendung in Verbindung mit Overhead Hoist Transport Systemen die Voraussetzung für direkte Streckenführungen zwischen Prozessanlagen bei sequenzieller Bearbeitung der Wafer ist.

Rückmeldungszeiten von Folge-Prozessschritten zur Steuerung der Vorgänger-Prozessschritte spielen oftmals ein wesentliche Rolle zur Einhaltung von spezifizierten Produktanforderungen.

Die Erfinder haben auch erkannt, dass im Vergleich zu herkömmlichen Wafer-Horden-Transporte, die bei Nasstransporten bisher mittels bodengebundenen Transportmitteln erfolgen, sich bei Verwendung von Overhead Hoist Transporten die Rückmeldungszeiten weiter reduzieren lassen und damit die Vorgängerprozesse besser steuern lassen.

Voraussetzung für Nasstransporte mit Overhead Hoist Transportsystemen ist die Verwendung besonders dafür geeigneter erfindungsgemäßer Transportbehälter.

Ein bevorzugter Transportbehälter zum Transport von Halbleiterscheiben wurde aus einem Grundmaterial mittels eines 3D Drucks mit einer vorgegebenen Form erzeugt.

Zumindest ein Bereich einer Oberfläche des Transportbehälters weist dabei ein Beschichtungsmaterial zum Schutz gegen Chemikalien auf.

Die in der Fertigung von Halbleiterscheiben verwendeten Chemikalien sind teilweise sauer oder alkalisch und Chemikalienreste oder gezielt zugeführte Chemikalien befinden sich auch innerhalb der Transportbehälter. Diesen Chemikalien gemein ist, dass sie in der Lage sind auch Oberflächen von Transportbehältern zu verätzen oder zu verunreinigen. Durch die beschriebene Beschichtung werden sowohl die Oberfläche gegen Verätzungen geschützt, die Anhaftung von Chemikalien und Verunreinigungen reduziert als auch die Reinigung der Behälter verbessert.

Die Beschichtung wurde dabei mittels eines Niedertemperatur-Beschichtungsverfahrens aufgebracht. Besonders bevorzug ist hierbei ein Niedertemperatur-Sinterverfahren zu nennen. Bevorzugt wird der Prozess bei einer Temperatur von unterhalb von 150°C, durchgeführt.

Die Beschichtung besteht dabei bevorzugt aus einem der Materialien Polytetrafluorethylen, Perfluoralkoxy-Polymer oder Polyvinylidenfluorid.

Eine vorgegebene Form des Transportbehälters enthält bevorzugt im Boden eine Vorrichtung, die geeignet ist, flüssige Medien abzuführen. Besonders bevorzugt ist diese Vorrichtung als Ventil ausgelegt, das die im Transportbehälter enthaltene Flüssigkeit schnell zu entleeren.

Das Ventil ist dabei besonders bevorzugt so ausgestaltet, dass es automatisch durch das Absetzen des Behälters geöffnet wird. Das Absetzen geschieht dabei auf einer geeigneten Station.

Oftmals werden Medien in den Transportbehältern für Nasstransporte von Halbleiterscheiben gezielt zu- und abgeleitet, damit Verunreinigungen nach Transporten gezielt und schnell beseitigt werden. In einem erfindungsgemäßen Transportbehälter lässt sich die möglichst umfangreiche und schnelle Entleerung durch integrierte und speziell dafür vorgesehene Schnellentleersysteme, typischerweise als sogenanntes "Quick Dump Valve" ausgeführt, realisieren und dadurch zur Vermeidung einer erneuten Anhaftung von Partikeln nach der Entfernung von Oberflächen - besser anpassen.

Es hat sich als besonders vorteilhaft erwiesen, wenn der Transportbehälter eine oder mehrere integrierte Werkstückaufnahmen für Halbleiterscheiben und/oder Träger für Halbleiterscheiben aufweist, so dass die zu transportierenden Halbleiterscheiben stehend beladen werden können.

Die auf dem Markt befindlichen Behälter zeichnen sich meist dadurch aus, dass sie so an ein Transportsystem angebaut werden, dass die Achse der Transportrichtung mit immer derselben Achse des Transportbehälters zusammenfallen. Es ist also nicht möglich den Behälter beispielsweise um 90° gedreht anzubauen. Es gibt für den Behälter also eine bestimmungsgemäße Transportachse.

Die Erfinder haben erkannt, dass die Halbleiterscheiben in einem Transportbehälter so gelagert werden, dass die Vorder- bzw. Rückseite der Halbleiterscheibe parallel zur bestimmungsgemäßen Transportrichtung verläuft.

Dies hat den Effekt, dass sich während des Transports bewegende Flüssigkeit keine oder nur unwesentliche Kraft auf die Halbleiterscheiben ausüben kann. Würden die Halbleiterscheiben beispielsweise um 90° verdreht transportiert, kommt es vermehr zu Schäden (Bruch).

Die Aufnahmen für die zu transportierenden Halbleiterscheiben innerhalb des 3D gedruckten Transportbehälters sind daher bevorzugt so angeordnet, dass sich während der Transporte die darin enthaltene Flüssigkeit zwischen den Halbleiterscheiben, parallel zu den Wafer-Oberflächen bewegen kann. Dadurch werden die Krafteinleitung durch schwappende Flüssigkeiten an den Wafer-Oberflächen reduziert, Relativbewegungen der Wafer in den Wafer-Aufnahmen minimiert und Beschädigungen an Wafer-Oberflächen vermieden.

Besonders vorteilhaft hat sich erwiesen, wenn die verwendeten Transportbehälter Energiespeicher für elektrische Energie enthalten, mit deren Hilfe elektrische Bauteile betrieben werden können.

Ganz besonders bevorzugt ist es, wenn zusätzlich Elemente zur elektronischen Datenverarbeitung, wie etwa ein mini PC, am Transportbehälter verbaut sind.

Die Anwendungsmöglichkeiten steigern sich dadurch erheblich, so können etwa mit verbauten geeigneten Sensoren, Bewegungsprofile aufgezeichnet werden, die für das Rückverfolgen im Fehlerfall von Nutzen sind.

### Abkürzungen

- 100: beschichteter Behälter
- 101: erste Schicht des herzustellenden Behälters
- 102: zweite Schicht des herzustellenden Behälters
- 103: weitere Schicht des herzustellenden Behälters
- 104: Druckkopf
- 105: Grundmaterial
- 106: 3-D-Drucker
- 107: Träger
- 108: Beschichtungsmaterial
- 109: Tank
- 110: Transportbehälter
- 111: Auftragungswerkzeug
- 112: Ofen

- 200: Transportfahrzeug des OHT
- 201: Deckel des Transportbehälters, fest montiert mir dem Transportfahrzeug des OHT
- 202: Transportbehälter
- 203: Trägersystem für einen Transportbehälter
- 204: Befestigungen für den vertikalen Transport des Transportfahrzeugs

- 300: Deckel des Behälters
- 301: Behälter
- 302: Halbleiterscheiben
- 303: Werkstückaufnahme für Halbleiterscheiben
- 304: Dichtungssystem zwischen Behälter und Deckel
- 305: Antriebseinheit, die die in dem Behälter unter Flüssigkeit gelagerten Halbleiterscheiben in Rotation versetzen kann.

### Figurenbeschreibung

- **Figur 1**: zeigt schematisch einen Ablauf eines bevorzugten Verfahrens in einer bevorzugten Ausführungsform.
- **Figur 2**: zeigt schematisch einen erfindungsgemäßen Transportbehälter in einer bevorzugten Ausführungsform.
- **Figur 3**: zeigt ebenfalls einen erfindungsgemäßen Transportbehälter in einer detaillierten Schnittdarstellung.

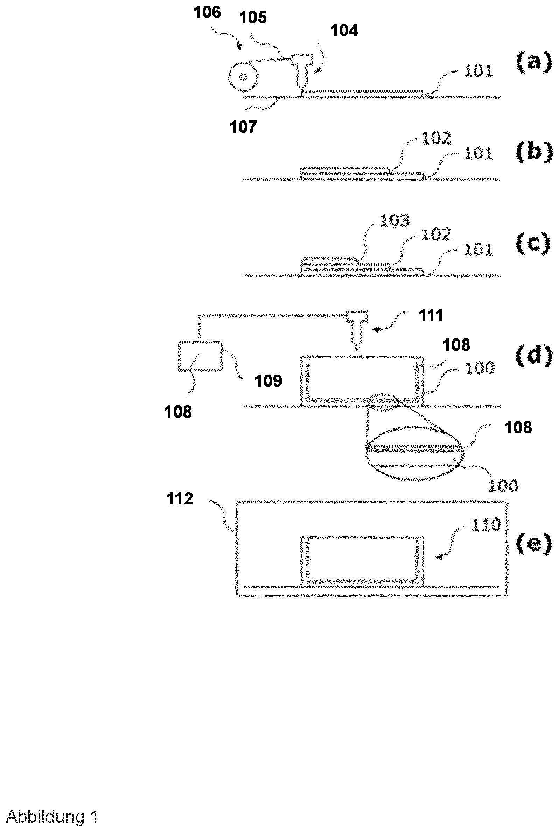

In **Figur 1** ist schematisch ein Ablauf eines Verfahrens in einer bevorzugten Ausführungsform dargestellt. Hierzu ist zunächst in Abbildung (**a**) grob schematisch eine Vorrichtung **106** für additives Aufbauverfahren, z.B. ein 3-D-Drucker, dargestellt, die einen Druckkopf **104** aufweist, dem ein Grundmaterial **105** zugeführt wird. Mittels des Druckkopfes **104** wird dann zunächst eine erste Schicht **101** des herzustellenden Behälters auf einen Träger **107** aufgebracht.

Im weiteren Verlauf werden weitere Schichten aufgebracht, und zwar indem jeweils eine neue Schicht auf die jeweils vorhergehende Schicht aufgebracht wird. Beispielhaft sind in Abbildung (**b**) eine weitere Schicht **102,** die auf die Schicht **101** aufgebracht wird, und in Abbildung (**c**) eine weitere Schicht **103,** die auf die Schicht **102** aufgebracht wird, gezeigt.

Auf diese Weise wird der Behälter **100** aus dem Grundmaterial mittels eines additiven Aufbauverfahrens in einer gewünschten bzw. vorgegebenen Form hergestellt, wie er grob schematisch in Abbildung (**d**) gezeigt ist. Wie ebenfalls in Abbildung (**d**) gezeigt, wird z.B. auf die innenliegenden Oberflächen des - oben offenen - Behälters **100** ein Beschichtungsmaterial **108** aufgebracht, beispielsweise mittels eines Auftragungswerkzeuges **111,** dem das Beschichtungsmaterial **108** aus einem Tank **109** zugeführt wird.

Der auf diese Weise beschichtete Behälter **100** wird dann z.B. in einem Ofen **112,** wie in Abbildung (**e**) gezeigt, für eine vorbestimmte Zeitdauer innerhalb eines vorbestimmten Temperaturbereichs, der unterhalb einer Formbeständigkeitstemperatur des Grundmaterials **105** liegt, z.B. bei 150°C, getrocknet, insbesondere gesintert. Auf diese Weise entsteht der fertige Transportbehälter **110,** der damit auch chemikalienbeständig ist.

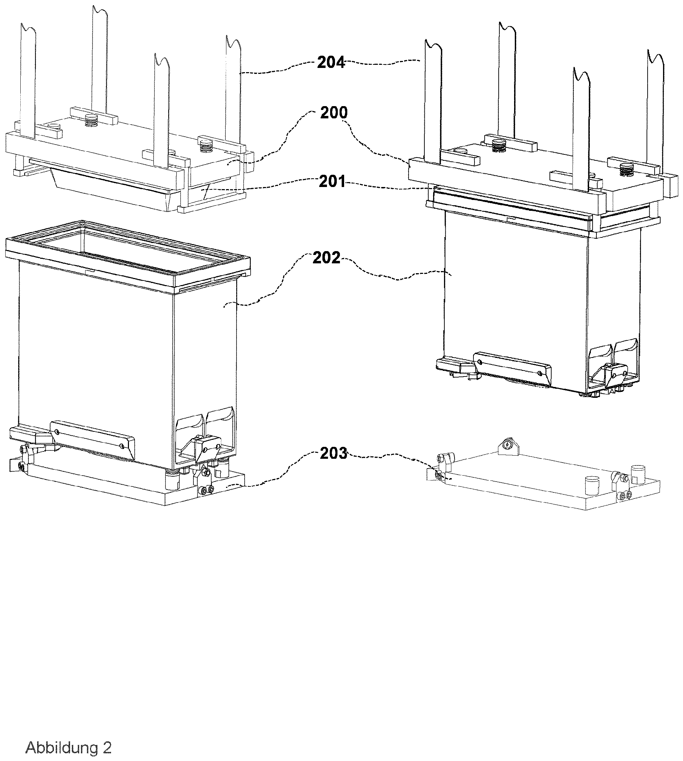

In **Figur 2** ist schematisch ein erfindungsgemäßer Transportbehälter **202** in einer bevorzugten Ausführungsform dargestellt, wie er beispielsweise mittels des in **Figur 1** gezeigten und in Bezug darauf beschriebenen Verfahrens hergestellt werden kann. Hierbei ist insbesondere die Form bzw. Formgebung des Transportbehälters **202** gezeigt, die bereits in Bezug auf **Figur 1** angesprochene Beschichtung mit dem Beschichtungsmaterial ist hier der Übersichtlichkeit halber nicht explizit gezeigt.

Der Deckel des Behälters **201** ist dabei fest montiert mit dem Transportfahrzeug des OHT **200,** das wiederum an Befestigungen **204** hängt, die geeignet sind das Transportfahrzeug vertikal zu bewegen.

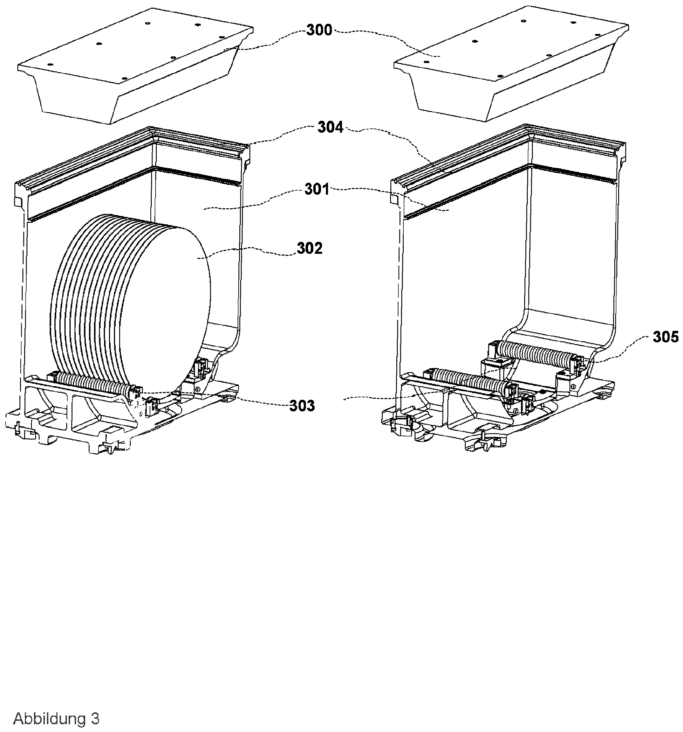

**Figur 3** zeigt zwei Schnitte durch einen bevorzugten Transportbehälter. Ein Deckel **300,** der mittels eines Dichtsystems **304** auf den Behälter **301** aufgelegt werden kann, schützt beim Transport des Behälters vor auslaufender Flüssigkeit. In dem Behälter können mehrere Halbleiterscheiben **302,** die in einer Werkstückaufnahme **303** gelagert sind, sicher transportiert werden. Die bevorzugte bestimmungsgemäße Transportrichtung des Transportbehälters ist entlang der Vorder-/ oder Rückseite der gelagerten Halbleiterscheiben **302**.

Eine besonders bevorzugte Antriebseinheit **305** sorgt dafür, dass die Halbleiterscheiben währen des Transportes in Rotation versetzt werden können und sich so keine Ablagerungsstellen für Verunreinigung an den Kanten der Halbleiterscheiben bilden können.

Wie schon mehrfach erwähnt, erlaubt das vorgeschlagene, additive Aufbauverfahren eine freie und damit optimierte Gestaltung von z.B. Wafer-Transportbehältern. Es sind keine An- und Einbaukomponenten, die die Prozesse innerhalb der Behälter beeinflussen, nötig, vielmehr kann der Behälter auch schweißnahtfrei und materialsparend aufgebaut werden. Chemikalienabflussöffnungen können an den prozessrelevanten Positionen angeordnet sein, dadurch wird eine exakte Abführung der reaktiven Chemikalien an und von den Wafer- und Behälter-Oberflächen sichergestellt.

Die Bauform lässt sich durch das 3 D Druckverfahren sehr genau auf ein erforderliches Flüssigkeitsvolumen, typischerweise sind eine bestimmte Anzahl von Wafern während Nasstransporte vollständig in der Flüssigkeit eingetaucht, zu transportieren. Wie in **Figur 3** zu sehen, ist die Form des Transportbehälters an eine bestimmte Anzahl von Wafern angepasst, damit ist auch das Volumen für z.B. darin einzubringende Flüssigkeiten auf ein nötiges Minimum reduziert.

Die Bauform ist fluidtechnisch optimiert, typischerweise für Wafer-Transporte, um dadurch den Abtransport von Partikeln und Chemikalienresten von Wafer- und Behälter-Oberflächen hin zu Abführungsöffnungen ohne erneute Anlagerung der Partikel an Oberflächen, zu erreichen. Bevorzugt ist hierfür eine am Behälterboden angeordnete, zentrale Öffnung für die Aufnahme eines Ventils zur schnellen Entleerung im Transportbehälter angebracht.

Weiterhin ist bevorzugt eine Werkstückaufnahme **304** vorgesehen, die im Rahmen der Herstellung des Transportbehälters durch entsprechende Formgebung in diesen integriert wird. In diese Werkstückaufnahme **304** kann bevorzugt ein Träger bzw. "Wafer-Carrier" bündig und sicher eingesetzt werden.

Besonders bevorzugt ist, dass in eine Werkstückaufnahme direkt eines oder mehrere Halbleiterscheiben (oder Wafer) - ohne Verwendung eines "Wafer-Carriers" - einsetzbar sind. Die Ausrichtung der Werkstückaufnahme ist bevorzugt so gestaltet, dass während Nass-Transporten mit befüllten Behältern keine Krafteinleitung durch schwappende Flüssigkeiten gegen die Wafer-Oberflächen erfolgt und dadurch verursachte Relativbewegungen der Wafer in den Wafer-Aufnahmen. Die Schlitze der Wafer-Aufnahmen werden in Transportrichtung der Behälter angeordnet.

Weiterhin sind integrierte Rahmen und Befestigungen (auch im Sinne mechanischer Kopplungselemente) für eine einfache Adaption mit Aufnahmevorrichtungen von Transportsystemen, z.B. Overhead Hoist Transportsystemen, möglich. Besonders bevorzugt sind gleichzeitig unterschiedliche, mechanische Kopplungselemente an der Unterseite des Transportbehälters vorgesehen. Die Kopplungselemente dienen der exakten und gleichbleibenden Positionierung an Prozessanlagen, z.B. für die Beladung mit Wafern mittels Robotersystemen ohne die Behälterposition mit speziellen Messverfahren zu erfassen.

Weiterhin ist beispielhaft eine Sensoraufnahme durch geeignete Formgebung ausgebildet, in die ein Sensor eingebracht werden kann, der z.B. der Überwachung eines bestimmten Füllgrades dienen kann.

An dieser Stelle sei noch erwähnt, dass die hier in die Form des Transportbehälters integrierten Komponenten bzw. Funktion nur beispielhaft sind. Es können auch weitere Komponenten bzw. Funktion vorgesehen sein. Je nach gewünschter Verwendung des Transportbehälters können auch nur bestimmte Komponenten bzw. Funktionen vorgesehen sein.

## Patentansprüche

1. Transportbehälter zum Transport von Halbleiterscheiben,
der aus einem Grundmaterial mittels eines 3D Drucks mit einer vorgegebenen Form erzeugt wurde,
wobei zumindest ein Bereich einer Oberfläche des Transportbehälters ein Beschichtungsmaterial zum Schutz gegen Chemikalien aufweist, die geeignet sind, die Halbleiterscheiben zu ätzen,
wobei das Beschichtungsmaterial mittels eines Niedertemperatur-Beschichtungsverfahrens, insbesondere eines Niedertemperatur-Sinterverfahrens, bevorzugt mit einer Temperatur unterhalb von 150°C, aufgebracht wurde,
und das Beschichtungsmaterial aus Polytetrafluorethylen, Perfluoralkoxy-Polymer oder Polyvinylidenfluorid besteht,
wobei die vorgegebene Form des Transportbehälters im Boden eine Vorrichtung enthält, die geeignet ist, flüssige Medien abzuführen,
und die vorgegebene Form des Transportbehälters eine oder mehrere integrierte Werkstückaufnahmen für Halbleiterscheiben und/oder Träger für Halbleiterscheiben aufweist, so dass die zu transportierenden Halbleiterscheiben stehend beladen werden können
und die bestimmungsgemäße Transportrichtung des Transportbehälters in einem automatischen Transportsystem parallel zu deren Vorder- oder Rückseite der Halbleiterscheiben verläuft.

2. Transportbehälter nach Anspruch 1,
wobei die Vorrichtung, die geeignet ist, flüssige Medien abzuführen, so ausgestaltet ist, dass sie automatisch durch das Absetzen des Behälters geöffnet wird.

3. Transportbehälter nach einem der vorstehenden Ansprüche,
enthaltend aktive Energiespeicher für elektrische Energie .

4. Transportbehälter nach einem der vorstehenden Ansprüche,
enthaltend ein System zur elektronischen Datenverarbeitung.

5. Transportbehälter nach einem der vorstehenden Ansprüche,
enthaltend eine oder mehrerer Befestigungseinrichtungen, die dazu geeignet sind, den Behälter sowohl einem bodengebundenen als auch an einem Deckengebundenen Transportsystem zu befestigen.

6. Transportbehälter nach einem der vorstehenden Ansprüche,
enthaltend einer oder mehrere Abdeckvorrichtungen zur Vermeidung von Flüssigkeitsaustritt während des Transportvorgangs.

7. Transportbehälter nach einem der vorstehenden Ansprüche,
wobei das Gewicht des mit Flüssigkeit und Halbleiterscheiben gefüllten Transportbehälter mehr als 15kg und weniger als 120 kg beträgt.

## Geänderte Patentansprüche

### Geänderte Patentansprüche gemäss Regel 137(2) EPÜ.

1. Transportbehälter (**301**) zum Transport von Halbleiterscheiben (302),
der aus einem Grundmaterial (**105**) mittels eines 3D Drucks mit einer vorgegebenen Form erzeugt wurde,
wobei zumindest ein Bereich einer Oberfläche des Transportbehälters (**301**) ein Beschichtungsmaterial (**108**) zum Schutz gegen Chemikalien aufweist, die geeignet sind, die Halbleiterscheiben (**302**) zu ätzen,
wobei das Beschichtungsmaterial (**108**) mittels eines Niedertemperatur-Beschichtungsverfahrens, insbesondere eines Niedertemperatur-Sinterverfahrens, bevorzugt mit einer Temperatur unterhalb von 150°C, aufgebracht wurde,
und das Beschichtungsmaterial (**108**) aus Polytetrafluorethylen, Perfluoralkoxy-Polymer oder Polyvinylidenfluorid besteht,
wobei die vorgegebene Form des Transportbehälters im Boden eine Vorrichtung enthält, die geeignet ist, flüssige Medien abzuführen,
und die vorgegebene Form des Transportbehälters eine oder mehrere integrierte Werkstückaufnahmen (**303**) für Halbleiterscheiben (**302**) und/oder Träger für Halbleiterscheiben (**302**) aufweist, so dass die zu transportierenden Halbleiterscheiben (**302**) stehend beladen werden können und die bestimmungsgemäße Transportrichtung des Transportbehälters (**301**) in einem automatischen Transportsystem parallel zu deren Vorder- oder Rückseite der Halbleiterscheiben verläuft.

2. Transportbehälter (**301**) nach Anspruch 1,
wobei die Vorrichtung, die geeignet ist, flüssige Medien abzuführen, so ausgestaltet ist, dass sie automatisch durch das Absetzen des Transportbehälters (**301**) geöffnet wird.

3. Transportbehälter (**301**) nach einem der vorstehenden Ansprüche,
enthaltend aktive Energiespeicher für elektrische Energie.

4. Transportbehälter (**301**) nach einem der vorstehenden Ansprüche,
enthaltend ein System zur elektronischen Datenverarbeitung.

5. Transportbehälter (**301**) nach einem der vorstehenden Ansprüche,
enthaltend eine oder mehrere Befestigungseinrichtungen, die dazu geeignet sind, den Behälter sowohl einem bodengebundenen als auch an einem deckengebundenen Transportsystem zu befestigen.

6. Transportbehälter (**301**) nach einem der vorstehenden Ansprüche,
enthaltend einer oder mehrere Abdeckvorrichtungen (**300**) zur Vermeidung von Flüssigkeitsaustritt während des Transportvorgangs.

7. Transportbehälter (**301**) nach einem der vorstehenden Ansprüche,
wobei das Gewicht des mit Flüssigkeit und Halbleiterscheiben (**302**) gefüllten Transportbehälters (**301**) mehr als 15 kg und weniger als 120 kg beträgt.

8. Verfahren zum Transportieren von Halbleiterscheiben (**302**) unter Verwendung eines Transportbehälters (**301**) nach einem der Ansprüche 1 bis 7.
